# EUROPEAN PATENT SPECIFICATION

(11) **EP 3 885 135 B1**
(45) Date of publication and mention of the grant of the patent: **10.01.2024**
(21) Application number: 19886905.9
(22) Date of filing: 18.11.2019
(51) Int. Cl.: B32B 27/00, B32B 27/20, H05K 7/20, B29C 70/88, H01L 23/36, H01L 23/373

(54) **THERMAL CONDUCTIVE SHEET AND METHOD FOR MANUFACTURING SAME**
WÄRMELEITENDE FOLIE UND VERFAHREN ZUR HERSTELLUNG DAVON
FEUILLE THERMOCONDUCTRICE ET PROCÉDÉ DE FABRICATION D'UNE TELLE FEUILLE THERMOCONDUCTRICE

(30) Priority: 20.11.2018 JP 2018217676
(43) Date of publication of application: 29.09.2021
(73) Proprietor: Sekisui Polymatech Co., Ltd., Saitama-city, Saitama 338-0837 (JP)
(72) Inventor: KUDOH, Hiroki, Saitama-city, Saitama 338-0837 (JP)
(74) Representative: Ter Meer Steinmeister & Partner
(86) International application number: PCT/JP2019/045144
(87) International publication number: WO 2020/105601

(56) References cited:
- WO-A1-2008/085999
- WO-A1-2009/008308
- WO-A1-2017/179318
- CN-A- 106 810 877
- JP-A- 2009 094 110
- JP-A- 2009 149 769
- JP-A- 2009 295 921
- JP-A- 2010 003 981
- JP-A- 2014 027 144
- JP-A- 2014 031 501
- JP-A- 2014 148 094
- JP-A- 2019 064 192
- JP-A- 2019 123 174
- US-A1- 2014 349 067

## Description

### Technical Field

The present invention relates to a heat-conducting sheet and a method for producing the same.

### Background Art

In electronic devices such as computers, automobile parts and cell phones, heat-dissipating elements such as heat sinks are usually used in order to dissipate heat generated from heating elements such as semiconductor devices and mechanical parts. For the purpose of raising the thermal conduction efficiency of heat to the heat-dissipating elements, it is known that a heat-conducting sheet is disposed between a heating element and a heat-dissipating element. The heat-conducting sheets are usually used by being compressed when disposed inside electronic devices and need high flexibility.

The heat-conducting sheets usually contain a polymer matrix and a heat-conducting filler dispersed in the polymer matrix. Then in the heat-conducting sheets, in order to enhance the thermal conduction in a specific direction, an anisotropic filler having anisotropy in its shape is oriented in one direction in some cases.

The heat-conducting sheet in which the anisotropic filler is oriented in one direction is produced, for example, by fabricating a plurality of primary sheets in which the anisotropic filler is oriented in the sheet plane direction by stretching or the like, and perpendicularly slicing a laminate made by laminating and unifying the plurality of primary sheets. According to this production method (hereinafter, referred to also as "flow orientation method"), there is obtained a heat-conducting sheet constituted by laminating a large number of unit layers each having a minute thickness. Further the anisotropic filler can be oriented in the sheet thickness direction (for example, see Patent Literature 1).

### Citation List

### Patent Literature

PTL1: JP No. 2014-27144 A

Prior art is also disclosed in documents JP2009 149769, JP2009 094110, WO2008/085999, US2014/0349067 and JP2014 148094.

### Summary of Invention

### Technical Problem

As polymer matrices for heat-conducting sheets, silicone resins are broadly used from the viewpoint of thermal conduction, heat resistance and the like. However, when a heat-conducting sheet is tried to be produced by the flow orientation method using a silicone resin as a polymer matrix, the adhesive force between the silicone resins is weak and deficiencies including exfoliation between a primary sheet and a primary sheet occur in some cases in a slicing step and the like.

In order to eliminate the above deficiencies, it is being studied that primary sheets are firmly mutually adhered by making a compound reactive with the silicone resin, such as an adhesive agent or a primer, to intervene between a primary sheet and a primary sheet. It is also being studied that primary sheets are firmly mutually adhered by making the primary sheets in a semi-cured state and superposing, compression bonding and secondarily curing the semi-cured primary sheets.

When the above adhesive agent or primer is made to intervene between primary sheets, however, the adhesive agent or primer does not stay on the surface layer of the primary sheets and penetrates into a certain depth and react, making a heat-conducting sheet hard and making deficiencies including loss of flexibility to be liable to be caused.

Then, according to the method of superposing primary sheets in a semi-cured state, since in addition to necessity of compression bonding to adhere the semi-cured primary sheets, a minimal hardness is necessary for the primary sheets, there arises such a problem that a heat-conducting sheet becomes harder than necessary.

That is, in the case where a heat-conducting sheet constituted by using a silicone resin as a matrix component and laminating a plurality of unit layers is produced by the conventional production methods, it is difficult for a heat-conducting sheet having high flexibility to be obtained.

Then, the present invention has such an object that in a heat-conducting sheet constituted by using a silicone resin as a matrix component and laminating a large number of unit layers, the flexibility is made high.

### Solution to Problem

As a result of exhaustive studies, the present inventor has found that the following constitutions can solve the above problem, and has completed the present invention. That is, the present invention provides the following [1] to [10].
[1] A heat-conducting sheet, comprising a plurality of unit layers each comprising a silicone resin, the plurality of unit layers being laminated so as to be adhered with each other,
   wherein at least one of the plurality of unit layers comprises a heat-conducting filler; and
   the heat-conducting sheet has a compression ratio of 20 to 65% as measured when the heat-conducting sheet is compressed at 0.276 MPa from the direction perpendicular to the adhesion surfaces of the plurality of unit layers adhered with each other.
[2] The heat-conducting sheet according to the above [1], wherein the plurality of unit layers are laminated along one direction along the sheet plane direction.
[3] The heat-conducting sheet according to the above [1] or [2], wherein the heat-conducting filler comprises an anisotropic filler.
[4] The heat-conducting sheet according to the above [3], wherein the heat-conducting filler further comprises a non-anisotropic filler.
[5] The heat-conducting sheet according to the above [3] or [4], wherein the anisotropic filler is oriented in the sheet thickness direction.
[6] The heat-conducting sheet according to any one of the above [2] to [5], wherein the anisotropic filler is at least one selected from the group consisting of fibrous materials and flake materials.
[7] The heat-conducting sheet according to the above [6], wherein the normal direction of the flake plane of the flake material is directed to the lamination direction of the plurality of unit layers.
[8] The heat-conducting sheet according to any one of the above [1] to [7], wherein the neighboring unit layers are mutually directly adhered.
[9] A method for producing a heat-conducting sheet, comprising:
   a step of preparing a plurality of primary sheets each comprising a silicone resin and having at least one of the primary sheets comprising a heat-conducting filler;
   a step of irradiating at least one surface of the primary sheet with vacuum ultraviolet rays;
   a step of laminating the plurality of primary sheets so that each one surface irradiated with vacuum ultraviolet rays is brought into contact with another primary sheet, to adhere the plurality of primary sheets to thereby form a laminated block; and
   a step of cutting the laminated block along the lamination direction so as to make a sheet shape, to thereby obtain the heat-conducting sheet.
[10] The method for producing a heat-conducting sheet according to the above [9], wherein the heat-conducting filler comprises an anisotropic filler, and the primary sheet comprises the anisotropic filler oriented along the sheet plane direction; and
   the laminated block is cut in the direction orthogonal to the orientation direction of the anisotropic filler.

### Advantageous Effects of Invention

According to the present invention, in a heat-conducting sheet constituted by using a silicone resin as a matrix component and laminating a plurality of unit layers, the flexibility can be made high.

### Brief Description of Drawings

[Fig. 1] Fig. 1 is a schematic cross-sectional view showing a heat-conducting sheet of a first embodiment.
[Fig. 2] Fig. 2 is a schematic perspective view showing an example of a production method of a heat-conducting sheet.
[Fig. 3] Fig. 3 is a schematic cross-sectional view showing a heat-conducting sheet of a second embodiment.

### Description of Embodiments

Hereinafter, heat-conducting sheets according to embodiments of the present invention will be described in detail.

### [First embodiment]

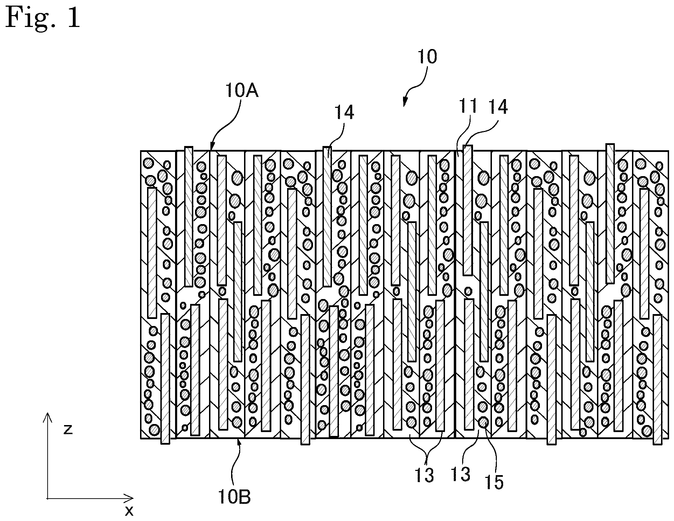

Fig. 1 shows a heat-conducting sheet of a first embodiment. The heat-conducting sheet 10 according to the first embodiment has a plurality of unit layers 13 each containing a silicone resin 11 and a heat-conducting filler. The plurality of unit layers 13 are laminated along one direction along the plane direction (that is, the one direction is one direction perpendicular to the thickness direction z, and referred to also as "lamination direction x"), and neighboring unit layers 13 are adhered with each other. In each unit layer 13, the silicone resin 11 becomes a matrix component holding the heat-conducting filler, and the heat-conducting filler is blended so as to be dispersed in the silicone resin 11.

The heat-conducting sheet 10 contains, as the heat-conducting filler, an anisotropic filler 14 and a non-anisotropic filler 15. The anisotropic filler 14 is oriented in the thickness direction z of the sheet 10. That is, the anisotropic filler 14 is oriented along one direction in the plane direction of each unit layer 13. By making the anisotropic filler 14 oriented in the sheet thickness direction z to be contained in the heat-conducting sheet 10, the thermal conduction in the thickness direction z is improved. Also, by further making the non-anisotropic filler 15 to be contained in the heat-conducting sheet 10, the thermal conduction is further improved.

The heat-conducting sheet 10 of the present invention has a compression ratio of 20 to 65% as measured when being compressed at 0.276 MPa (= 40 psi). With the compression ratio being lower than 20%, the flexibility is insufficient and use thereof in being compressed inside electronic devices and the like becomes difficult. Then with the compression ratio exceeding 65%, in production of the heat-conducting sheet 10, each unit layer 13 is spread out by the pressure when the unit layers 13 are laminated, and the heat-conducting sheet 10 cannot suitably be produced in some cases.

From the viewpoint of more improving the flexibility, the compression ratio is preferably 25% or higher and more preferably 35% or higher. Then from the viewpoint of preventing spreading out of each unit layer 13 in production to raise the production efficiency, the compression ratio is preferably 60% or lower and more preferably 55% or lower.

Here, the compression ratio used in the present invention is a value measured when the heat-conducting sheet 10 is compressed from the direction perpendicular to adhesion surfaces adhered with each other of the plurality of unit layers 13; specifically, the heat-conducting sheet 10 may be compressed in the thickness direction thereof for the measurement. The compression ratio is a parameter, expressed as "(T1 - T2)/T1, indicating the proportion of the amount compressed to the initial thickness where T1 represents the initial thickness before compression and T2 represents the thickness when the heat-conducting sheet 10 is compressed at a predetermined pressure.

### (Silicone resin)

The silicone resin 11 is not especially limited as long as being an organopolysiloxane, but it is preferable to use a curing type silicone resin. In the case where the silicone resin 11 is of a curing type, the silicone resin 11 is obtained by curing a curing silicone composition. As the silicone resin 11, an addition reaction-type silicone resin may be used or a silicone resin other than that may be used. In the case of the addition reaction-type silicone resin, the curing silicone composition is preferably composed of a silicone compound to make a base resin and a curing agent to cure the base resin.

The silicone compound to be used as the base resin is preferably an alkenyl group-containing organopolysiloxane, and specifically includes vinyl-both terminated organopolysiloxanes such as vinyl-both terminated polydimethylsiloxanes, vinyl-both terminated polyphenylmethylsilxanes, vinyl-both terminated dimethylsiloxane-diphenylsiloxane copolymers, vinyl-both terminated dimethylsiloxane-phenylmethylsiloxane copolymers and vinyl-both terminated dimethylsiloxane-diethyksiloxane copolymers.

The curing agent is not especially limited as long as being capable of curing the above silicone compound being the base resin, but is preferably an organohydrogenpolysiloxane which is an organopolysiloxane having two or more hydrosilyl groups (SiH).

By suitably regulating the blend amount ratio of the curing agent to the base resin, the hardness of a primary sheet described later can be regulated. Specifically, by making low the blend amount ratio of the curing agent to the base resin, the hardness of the primary sheet can be made low.

The content of the silicone resin is, in terms of % by volume (filling ratio), with respect to the total amount of the heat-conducting sheet, preferably 20 to 50% by volume and more preferably 25 to 45% by volume.

In the present invention, neighboring unit layers 13, 13 are adhered with each other, and it is preferable that each unit layer 13 is adhered directly with a neighboring unit layer 13. That is, it is preferable that neighboring unit layers 13, 13 are directly adhered without intervention of a material other than a unit layer, such as an adhesive agent. Such a constitution, since each unit layer 13 uses the silicone resin 11 as the matrix component as described above, brings about mutual adhesion of the silicone resins 11.

Although the mutual adhesion of the silicone resins 11 in a high adhesive force is generally difficult, in the present embodiment, as described later, since the adhesion surface of the unit layer 13 is activated by being irradiated with VUV, neighboring unit layers 13, 13 are mutually adhered in a relatively high adhesive force. Therefore, no exfoliation at the interface between the unit layers 13 is caused. Further since the unit layers 13, 13 are mutually adhered without intervention of another member nor utilization of curing or the like, the heat-conducting sheet 10 becomes enabled to secure the above compression ratio without impairing the flexibility.

### (Anisotropic filler)

The anisotropic filler 14 is a filler having a shape anisotropy and is a filler capable of being oriented. The anisotropic filler 14 includes fibrous materials and flake materials. In the anisotropic filler 14, the aspect ratio is generally high, and exceeds 2 and is more preferably 5 or higher. By making the aspect ratio to be higher than 2, it becomes easy for the anisotropic filler 14 to be oriented in the thickness direction z, and it becomes easy for the thermal conduction of the heat-conducting sheet 10 to be raised.

The upper limit of the aspect ratio is not especially limited, but is practically 100.

Here, the aspect ratio is the ratio of the length in the major axis direction of the anisotropic filler 14 to the length in the minor axis direction thereof; and for the fibrous materials, it means the fiber length/fiber diameter, and for the flake materials, it means the length in the major axis direction/thickness of the flake materials.

The content of the anisotropic filler 14 in the heat-conducting sheet is, with respect to 100 parts by mass of the silicone resin, preferably 10 to 500 parts by mass and more preferably 50 to 350 parts by mass. The content of the anisotropic filler 14 is, when expressed as a filling ratio in terms of volume (volume filling ratio), with respect to the total amount of the heat-conducting sheet, preferably 2 to 40% by volume and more preferably 8 to 30% by volume.

By making the content of the anisotropic filler 14 to be 10 parts by mass or higher, it becomes easy for the thermal conduction to be raised; and by making that to be 500 parts by mass or lower, it becomes easy for the viscosity of a liquid composition described later to become suitable and the orientation property of the anisotropic filler 14 becomes good.

For the anisotropic filler 14, in the case of a fibrous material, the average fiber length is preferably 10 to 500 µm and more preferably 20 to 350 µm. By making the average fiber length to be 10 µm or longer, in the heat-conducting sheet 10, the anisotropic fillers suitably mutually contact with each other and the heat transfer passages are secured, making the thermal conduction of the heat-conducting sheet 10 to become good.

On the other hand, by making the average fiber length to be 500 µm or shorter, the bulkiness of the anisotropic filler becomes low and the anisotropic filler becomes enabled to be filled highly in the silicone resin. Further even when an anisotropic filler having electrical conductivity is used as the anisotropic filler 14, the electrical conductivity of the heat-conducting sheet 10 is prevented from becoming higher than necessary.

Here, the average fiber length can be calculated by observing the anisotropic filler by a microscope. More specifically, for example, for the anisotropic filler 14 separated from the heat-conducting sheet 10 by dissolving the matrix component thereof, the fiber lengths of any 50 anisotropic fillers were measured by using an electron microscope or an optical microscope and their average value (arithmetic average value) can be taken as an average fiber length. At this time, no large shearing action is made to be exerted so as not to crush the fibers. Then in the case where separation of the anisotropic filler 14 from the heat-conducting sheet 10 is difficult, the average fiber length may be calculated by measuring the fiber lengths of the anisotropic filler 40 by using an X-ray CT device.

Further the diameter of the anisotropic filler 14 can also be measured similarly by using an electron microscope, an optical microscope or an X-ray CT device.

Here, in the present invention, "any" means random sampling.

In the case where the anisotropic filler 14 is the flake material, the average particle diameter is preferably 10 to 400 µm and more preferably 15 to 300 µm, and especially preferably 20 to 200 µm. By making the average particle diameter to be 10 µm or larger, in the heat-conducting sheet 10, it becomes easy for the anisotropic fillers 14 to contact with each other and the heat transfer passages are secured, making the thermal conduction of the heat-conducting sheet 10 to become good. On the other hand, by making the average particle diameter to be 400 µm or smaller, the bulkiness of the anisotropic filler 14 becomes low and the anisotropic filler 14 becomes enabled to be filled highly in the silicone resin 11.

Here, the average particle diameter of the flake material can be calculated by observing the anisotropic filler by a microscope and taking the major axis diameter as its diameter. More specifically, as in the above average fiber length, the major axis diameters of any 50 anisotropic fillers were measured by using an electron microscope, an optical microscope or an X-ray CT device and their average value (arithmetic average value) can be taken as an average particle diameter.

The thickness of the anisotropic filler 14 can also be measured similarly by using an electron microscope, an optical microscope or an X-ray CT device.

As the anisotropic filler 14, a well-known material having thermal conduction may be used. Further the anisotropic filler 14 may have electrical conductivity or may have insulativeness. When the anisotropic filler 14 has insulativeness, since the insulativeness in the thickness direction z of the heat-conducting sheet 10 can be raised, the heat-conducting sheet 10 becomes enabled to be used suitably in electric devices. Here, in the present invention, "having electrical conductivity " refers to the case where, for example, the volume resistivity is 1 × 10⁹ Ω·cm or lower. Then, "having insulativeness" refers to the case where, for example, the volume resistivity exceeds 1 × 10⁹ Ω·cm.

The anisotropic filler 14 specifically includes carbon-based materials represented by carbon fibers and flake carbon powder, metal materials represented by metal fibers and metal oxides, boron nitride and metal nitrides, metal carbides, metal hydroxides, and polyparaphenylene benzoxazole fibers. Among these, the carbon-based materials are preferable because the specific gravity is low and the dispersibility thereof in the silicone resin 11 is good; and among these, graphitized carbon materials, which have a high thermal conductivity, are more preferable. The boron nitride and the polyparaphenylene benzoxazole fibers are preferable from the viewpoint of having insulativeness; and among these, boron nitride is more preferable. The boron nitride is not especially limited, but is used preferably as a flake material. The flake boron nitride may be agglomerated or may not be agglomerated, but it is preferable that a part or the whole thereof is not agglomerated.

In the anisotropic filler 14, the thermal conductivity along the direction having anisotropy (that is, major axis direction) is, though not especially limited, generally 30 W/m.K or higher and preferably 100 W/m.K or higher. In the thermal conductivity of the anisotropic filler 14, the upper limit is not especially limited, and is, for example, 2,000 W/m.K or lower. A method of measuring the thermal conductivity is a laser flash method.

The anisotropic filler 14 may be used singly or concurrently in two or more. As the anisotropic filler 14, for example, there may be used an anisotropic filler 14 having at least two anisotropic fillers having different average particle diameters or different average fiber lengths. It is conceivable that when anisotropic fillers having different sizes are used, relatively smaller anisotropic fillers enter between relatively larger anisotropic fillers, whereby the anisotropic filler can be filled in a high density in the silicone resin and the heat transfer efficiency can be raised.

The carbon fiber to be used as the anisotropic filler 14 is preferably a graphitized carbon fiber. Then, the flake carbon powder is preferably a flake graphite powder. Among these, the anisotropic filler 14 is more preferably the graphitized carbon fiber.

The graphitized carbon fiber has graphite crystal planes ranging in the fiber axis direction and has a high thermal conductivity in the fiber axis direction. Hence, by uniformly aligning their fiber axis directions in a predetermined direction, the thermal conductivity in a specific direction can be raised. Further the flake graphite powder has graphite crystal planes ranging in the in-plane direction of the flake surface and has a high thermal conductivity in the in-plane direction. Hence, by uniformly aligning the flake surfaces in a predetermined direction, the thermal conductivity in a specific direction can be raised. The graphitized carbon fiber and the flake graphite powder preferably have a high degree of graphitization.

As the graphitized carbon materials such as the above graphitized carbon fiber, materials made by graphitizing the following raw materials can be used. Examples of the raw materials include condensed polycyclic hydrocarbon compounds such as naphthalene, PAN (polyacrylonitrile) and condensed heterocyclic compounds such as a pitch, but it is preferable to use particularly a mesophase pitch having a high degree of graphitization, polyimide or polybenzazole. For example, by using the mesophase pitch, in a spinning process described later, the pitch is oriented in the fiber axis direction due to its anisotropy, whereby there can be obtained a graphitized carbon fiber having an excellent thermal conduction in the fiber axis direction.

The use form of the mesophase pitch in the graphitized carbon fiber is not especially limited as long as being capable of being spun, and the mesophase pitch may be used singly or in a combination with other raw materials. However, single use of the mesophase pitch, that is, a graphitized carbon fiber having a content of the mesophase pitch of 100%, is most preferable from the viewpoint of the thermal conduction enhancement, the spinning property and the quality stability.

The graphitized carbon fiber can be used which is obtained by subjecting a raw material successively to each treatment of spinning, oxidation treatment and carbonization, and crushing or cutting the resultant into a predetermined particle diameter, and thereafter graphitizing the resultant, or after carbonization, crushing or cutting the resultant and thereafter graphitizing the resultant. In the case of crushing or cutting before graphitization, since it becomes easy for the polycondensation reaction and the cyclization reaction in the graphitization treatment to progress on the surface newly exposed by the crushing, there can be obtained the graphitized carbon fiber raised in the degree of graphitization and more improved in the thermal conduction. On the other hand, in the case where crushing is carried out after a spun carbon fiber is graphitized, the carbon fiber after the graphitization, since being rigid, is easily crushed, and carbon fiber powder having a relatively narrow fiber length distribution can be obtained by the crushing in a short time.

The average fiber length of the graphitized carbon fiber is preferably 50 to 500 µm and more preferably 70 to 350 µm. The aspect ratio of the graphitized carbon fiber exceeds 2 as described above and is preferably 5 or higher. The thermal conductivity of the graphitized carbon fiber is not especially limited, but the thermal conductivity in the fiber axis direction is preferably 400 W/m.K or higher and more preferably 800 W/m.K or higher.

The anisotropic filler 14 is oriented in the thickness direction z of the heat-conducting sheet in each unit layer. More specifically explaining the orientation in the thickness direction z of the anisotropic filler 14, when the heat-conducting filler 14 is a fibrous filler, the being oriented refers to such a state that the proportion of the number of the anisotropic fillers, that is, the fibrous fillers, whose major axes make an angle of smaller than 30° against the thickness direction z of the heat-conducting sheet 10, exceeds 50% with respect to the total amount of the anisotropic filler, and the proportion preferably exceeds 80%.

Then, when the anisotropic filler 14 is a flake filler, the being oriented refers to such a state that the proportion of the number of the anisotropic fillers whose flake surfaces make an angle of smaller than 30° against the thickness direction z of the heat-conducting sheet 10 exceeds 50% with respect to the total amount of the anisotropic filler, and the proportion can be preferably made to exceed 80%. In other words, the being oriented refers to such a state that the proportion of the number of the anisotropic fillers, that is, the flake fillers, whose normal directions of flake surfaces make an angle of smaller than 30° against the sheet plane (x-y plane) of the heat-conducting sheet, is in the state exceeding 50% with respect to the total amount of the anisotropic filler, and the proportion preferably exceeds 80%.

Then, with regard to the orientation direction of the anisotropic filler 14, from the viewpoint of raising the thermal conductivity, it is preferable that the angle made by the major axis or the angle made by the flake surface against the thickness direction z is made to be 0° or larger and smaller than 5°. On the other hand, from the viewpoint that the load when heat-conducting sheet 10 is compressed can be made low, the angle may be tilted in the range of 5° or larger and smaller than 30°. Here, these angles refer to average values of the orientation angles of a certain number (for example, any 50 anisotropic fillers 14) of the anisotropic fillers 14.

Further when the heat-conducting filler 14 is neither of the fibrous one nor the flake one, the being oriented refers to such a state that the proportion of the number of the anisotropic fillers 14 whose major axes make an angle of smaller than 30° against the thickness direction z of the heat-conducting sheet 10 exceeds 50% with respect to the total amount of the anisotropic filler, and the proportion is preferably made to exceed 80%.

In the case where the anisotropic filler 14 is the flake material, it is preferable that the normal direction of the flake surface is directed to a predetermined direction; specifically, it is preferable that the normal direction is directed to the lamination direction x of the plurality of unit layers 13. By thus making the normal direction to direct to the lamination direction x, there is improved the thermal conduction in the thickness direction z of the heat-conducting sheet 10. There is improved also the thermal conduction in the direction along the plane direction of the heat-conducting sheet 10 and orthogonal to the lamination direction x.

Here, that the normal direction of the flake surface is directed to the lamination direction x refers to such a state that the proportion of the number of the carbon fiber powder whose normal directions make an angle of smaller than 30° against the lamination direction x exceeds 50%, and the proportion preferably exceeds 80%.

In the case where the anisotropic filler 14 is the flake material, as described in a production method described later, by forming the primary sheet into a sheet shape under impartation of a shearing force, the normal direction of the flake surface results in being directed to the lamination direction x.

### <Non-anisotropic filler>

The non-anisotropic filler 15 is a heat-conducting filler, separately from the anisotropic filler 14, contained in the heat-conducting sheet 10, and is a material, together with the anisotropic filler 14, to impart the thermal conduction to the heat-conducting sheet 10. In the present embodiment, by making the non-anisotropic filler 15 to be contained, the filler intervenes in gaps between the oriented anisotropic fillers 14 and the heat-conducting sheet 10 high in the thermal conductivity is obtained.

The non-anisotropic filler 15 is a filler having substantially no shape anisotropy, and is the filler not being oriented in a predetermined direction even in such an environment that the anisotropic filler 14 is oriented in a predetermined direction, including under the action of the shearing force described later.

In the non-anisotropic filler 15, the aspect ratio is 2 or lower and more preferably 1.5 or lower. In the present embodiment, by making the non-anisotropic filler 15 thus low in the aspect ratio to be contained, the filler having thermal conduction suitably intervenes in gaps between the anisotropic fillers 14 and the heat-conducting sheet 10 high in the thermal conductivity is obtained. Then by making the aspect ratio to be 2 or lower, the viscosity of a liquid composition described later is prevented from rising and high filling is enabled.

The non-anisotropic filler 15 may have electroconductivity, but preferably has insulativeness; in the heat-conducting sheet 10, it is preferable that both the anisotropic filler 14 and the non-anisotropic filler 15 have insulativeness. When both the anisotropic filler 14 and the non-anisotropic filler 15 are insulative, it becomes easy for the insulativeness in the thickness direction z of the heat-conducting sheet 10 to be more raised.

Specific examples of the non-anisotropic filler 15 include metals, metal oxides, metal nitrides, metal hydroxides, carbon materials, and oxides, nitrides and carbides of nonmetals. The shape of the non-anisotropic filler 14 includes spherical shapes and indeterminate powder shapes.

In the non-anisotropic filler 15, examples of the metals include aluminum, copper and nickel; examples of the metal oxides include aluminum oxide represented by alumina, magnesium oxide and zinc oxide; and examples of the metal nitrides include aluminum nitride. The metal hydroxides include aluminum hydroxide. Further the carbon materials include spherical graphite. The oxides, nitrides and carbides of nonmetals include quartz, boron nitride and silicon carbide.

Among these, aluminum oxide and aluminum are preferable in that the thermal conductivity is high and spherical ones are easily available; and aluminum hydroxide is preferable in that the aluminum hydroxide is easily available and the fire retardancy of the heat-conducting sheet can be enhanced.

The non-anisotropic filler 15 having insulativeness includes, among those described above, metal oxides, metal nitrides, metal hydroxides and metal carbides, but particularly aluminum oxide and aluminum hydroxide are preferable.

The non-anisotropic filler 15 may be used singly in one kind among those described above or may be used concurrently in two or more kinds thereof.

The average particle diameter of the non-anisotropic filler 15 is preferably 0.1 to 50 µm and more preferably 0.5 to 35 µm, and especially preferably 1 to 15 µm. By making the average particle diameter to be 50 µm or smaller, occurrence of deficiencies including disturbance of the orientation of the anisotropic filler 14 becomes difficult. Then by making the average particle diameter to be 0.1 µm or larger, the specific surface area of the non-anisotropic filler 15 does not become larger than necessary; even when a large amount thereof is blended, the viscosity of a liquid composition hardly rises; and it becomes easy for the non-anisotropic filler 15 to be highly filled.

Here, the average particle diameter of the non-anisotropic filler 15 can be measured by observation with an electron microscope or the like. More specifically, as in the measurement in the above anisotropic filler, the particle diameters of any 50 non-anisotropic fillers were measured by using an electron microscope, an optical microscope or an X-ray CT device and their average value (arithmetic average value) can be taken as an average particle diameter.

The content of the non-anisotropic filler 15 in the heat-conducting sheet 10 is, with respect to 100 parts by mass of the silicone resin, preferably in the range of 50 to 1,500 parts by mass and more preferably in the range of 200 to 800 parts by mass. By making the content to be 50 parts by mass or higher, the amount of the non-anisotropic filler 15 intervening in gaps between anisotropic fillers 14 becomes not smaller than a certain amount and the thermal conduction becomes good. On the other hand, by making the content to be 1,500 parts by mass or lower, an effect of enhancing the thermal conduction corresponding to the content can be attained and there occurs no inhibition of the heat transfer by the anisotropic filler 14 due to the non-anisotropic filler 15. Then by making the content to be in the range of 200 to 800 parts by mass, the heat-conducting sheet 10 becomes excellent in the thermal conduction and the viscosity of a liquid composition also becomes suitable.

The content of the non-anisotropic filler 15 is, in % by volume, with respect to the total amount of the heat-conducting sheet, preferably 10 to 75% by volume and more preferably 30 to 60% by volume.

In the present embodiment, each unit layer 13 has substantially the same composition. Therefore, the contents of the anisotropic filler, the non-anisotropic filler and the silicone resin are the same as those in the heat-conducting sheet, and the contents of the anisotropic filler, the non-anisotropic filler and the silicone resin in each unit layer are also as described above.

### (Additive components)

In the heat-conducting sheet 10, the silicone resin 11 may be blended with various additives in the range of not impairing the functions as the heat-conducting sheet 10. Examples of the additives include at least one selected from the group consisting of dispersants, coupling agents, pressure-sensitive adhesives, fire retardants, antioxidants, colorants and suspending agents. In the case of curing the curing silicone composition as described above, a curing catalyst to catalyze curing may be blended as an additive. The curing catalyst includes platinum-based catalysts. Further the silicone resin 11 may be mixed with resin components other than the silicone resin as additive components in the range of not impairing the advantageous effects of the present invention.

### (Heat-conducting sheet)

The thermal conductivity in the thickness direction z of the heat-conducting sheet 10 is, for example, 5 W/(m.K) or higher, and preferably made to be 7 W/(m.K) or higher and more preferably 9 W/(m.K) or higher. By making the thermal conductivity to be not lower than these lower limit values, the heat-conducting sheet 10 excellent in the thermal conductivity in the thickness direction z can be made. The upper limit is not especially limited, but the thermal conductivity in the thickness direction z of the heat-conducting sheet 10 is, for example, 50 W/(m.K) or lower. Here, the thermal conductivity is measured by the method according to ASTM D5470-06.

The type OO hardness of the heat-conducting sheet 10 is, for example, 62 or lower. By making the type OO hardness of the heat-conducting sheet 10 to be 62 or lower, the flexibility is secured and the conformability to, for example, a heating element and a heat-dissipating element becomes good and the heat dissipation easily becomes good. Further from the viewpoint of improving the flexibility and making the conformability and the like excellent, the type OO hardness of the heat-conducting sheet 10 is preferably 50 or lower and more preferably 45 or lower.

Then the type OO hardness of the heat-conducting sheet 10 is, though not especially limited, for example, 15 or higher, preferably 18 or higher and more preferably 25 or higher.

In the present embodiment, on both surfaces 10A, 10B of the heat-conducting sheet 10, the anisotropic filler 14 is exposed. The exposed anisotropic filler 14 may be protruded from both the surfaces 10A, 10B. In the heat-conducting sheet 10, by the exposure of the anisotropic filler 14 on both the surfaces 10A, 10B, both the surfaces 10A, 10B make non-adhesive surfaces. In the heat-conducting sheet 10, since both the surfaces 10A, 10B become cut surfaces by cutting with a blade described later, the anisotropic filler 14 is exposed on both the surfaces 10A, 10B.

On one or both of the surfaces 10A, 10B, however, the anisotropic filler 14 may not be exposed and the one or both may make adhesive surfaces.

The thickness of the heat-conducting sheet 10 may suitably be varied according to shapes and applications of electronic devices on which the heat-conducting sheet 10 is mounted. The thickness of the heat-conducting sheet 10 is not especially limited, but the heat-conducting sheet 10 is used, preferably, for example, in the range of 0.1 to 5 mm.

Further the thickness of each unit layer 13 is not especially limited, but is preferably 0.1 to 2.0 mm and more preferably 0.3 to 0.8 mm. Here, the thickness of the unit layer 13 is the length of the unit layer 13 along the lamination direction x of the unit layer 13.

The heat-conducting sheet 10 is used inside electronic devices and the like. Specifically, the heat-conducting sheet 10 is made to intervene between a heating element and a heat-dissipating element, and transfers heat generated by the heating element to the heat-dissipating element, and makes the heat to be dissipated from the heat-dissipating element. Here, the heating element includes various types of electronic parts such as CPU, power amplifiers and power sources used inside electronic devices. The heat-dissipating element includes heat sinks, heat pumps, and metal housings of electronic devices. The heat-conducting sheet 10 is used by making both the surfaces 10A, 10B to be tightly adhered and compressed on the heating element and the heat-dissipating element, respectively.

### <Method for producing the heat-conducting sheet>

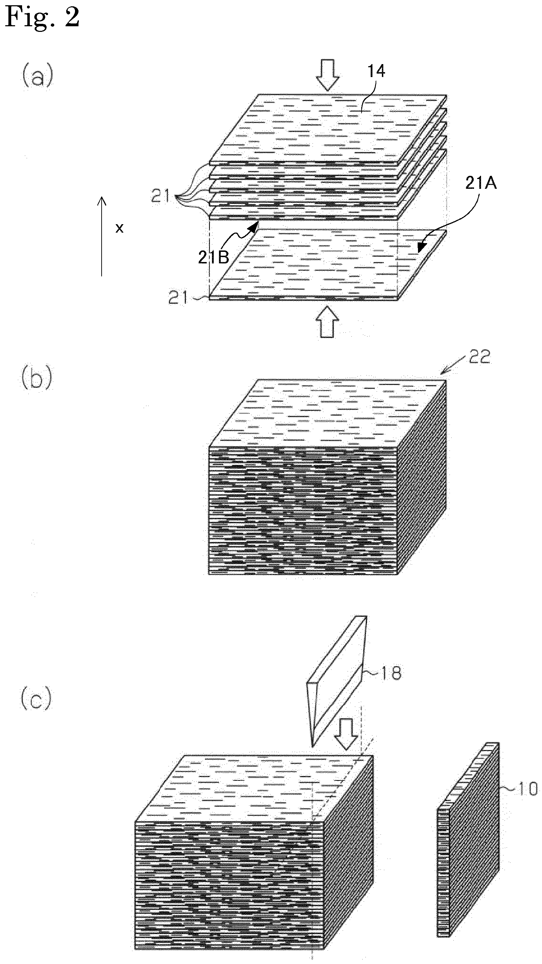

Then, one example of a method for producing the above heat-conducting sheet according to the first embodiment will be described by reference to Fig. 2. The present production method has a primary sheet preparation step of preparing a plurality of primary sheets each containing a silicone resin and a heat-conducting filler, a VUV irradiation step of irradiating the primary sheets with VLTV, a lamination step of laminating the primary sheets irradiated with VUV to obtain a laminated block, and a cutting step of cutting the laminated block to thereby obtain heat-conducting sheets. Hereinafter, each step will be described in detail.

### (Primary sheet preparation step)

In the primary sheet preparation step, first, a curing silicone composition being a raw material of the silicone resin, and the heat-conducting filler (that is, the anisotropic filler 14 and the non-anisotropic filler 15) are mixed to thereby prepare a liquid composition. The liquid composition usually becomes a slurry. The liquid composition, as required, may further suitably be mixed with additive components. Here, for mixing the respective components constituting the liquid composition, well-known means, for example, a kneader, a kneading roll, a mixer or the like may be used.

The viscosity of the liquid composition can be determined according to means of sheet formation and a desired thickness of a sheet. In the case where sheet formation is carried out by coating the liquid composition on a base material, the viscosity of the liquid composition is preferably 50 to 10,000 Pa s. By making the viscosity to be 50 Pa s or higher, it becomes easy for the anisotropic filler to be oriented in the primary sheet plane direction by imparting a shearing force. By making the viscosity to be 10,000 Pa s or lower, the coatability becomes good.

Here, the viscosity is a viscosity measured at a rotating speed of 1 rpm by using a rotational viscometer (Brookfield viscometer DV-E, spindle SC4-14), and the measuring temperature is a temperature at which the liquid composition is coated.

The curing silicone composition usually becomes a liquid; and the liquid composition is made to have the above viscosity by suitably regulating the molecular weight and the like of each component (alkenyl group-containing organopolysiloxane, organohydrogenpolysiloxane and the like) constituting the curing silicone composition. Then the liquid composition is allowed to be blended, as required, with an organic solvent in order to suitably regulate the viscosity to the above viscosity, but it is preferable that no organic solvent is blended.

Then, by forming the liquid composition into a sheet shape while applying a shearing force, the anisotropic filler 14 is oriented in the direction parallel with the sheet surface (that is, plane direction). Here, it is preferable that the liquid composition is coated on a base material film, for example, by using a coating applicator such as a bar coater or a doctor blade, or by discharge from extrusion or a nozzle, or the like; by such a method, there can be imparted the shearing force along the coating direction of the liquid composition. The anisotropic filler 14 in the liquid composition is oriented in the coating direction by being imparted with the shearing force.

Then, the liquid composition formed into a sheet shape is cured to thereby obtain a primary sheet. In the primary sheet, as described above, the anisotropic filler is oriented along the plane direction. The curing of the liquid composition is carried out by curing the curing silicone composition contained in the liquid composition. The curing of the liquid composition is carried out preferably by heating, but carried out preferably, for example, at a temperature of about 50 to 150°C. Then the curing time is, for example, about 10 min to 3 hours.

In the case where a solvent is blended in the liquid composition, the solvent is preferably volatilized by heating in the curing.

The thickness of the primary sheet obtained by the curing is preferably in the range of 0.1 to 2.0 mm. By making the thickness of the primary sheet in the above range, the anisotropic filler 14 can suitably be oriented in the plane direction by a shearing force. By making the thickness of the primary sheet to be 0.1 mm or larger, the primary sheet can easily be peeled off the base material film. By making the thickness of the primary sheet to be 2.0 mm or smaller, the primary sheet is prevented from deforming by its own weight. From these viewpoints, the thickness of the primary sheet is more preferably 0.3 to 0.8 mm.

The type OO hardness of the primary sheet is preferably 6 or higher. By making the type OO hardness to be 6 or higher, the primary sheet does not so much spread out even by being pressed in lamination of the primary sheets, and a laminated block having a sufficient thickness can be fabricated. From such a viewpoint, the type OO hardness of the primary sheet is more preferably 10 or higher and still more preferably 15 or higher.

Further from the viewpoint of securing the flexibility of an obtained heat-conducting sheet, the type OO hardness of the primary sheet is preferably 55 or lower, more preferably 50 or lower and still more preferably 40 or lower.

### (VUV irradiation step)

Then, at least one surface of the cured primary sheet is irradiated with VUV. The VLTV is vacuum ultraviolet rays and means ultraviolet rays of 10 to 200 nm in wavelength. A light source of VLTV includes excimer Xe lamps and excimer ArF lamps.

The cured primary sheet, as described above, contains the silicone resin (organopolysiloxane), and when the primary sheet is irradiated with VUV, the surface irradiated with VUV is activated. By superposing the primary sheet on another primary sheet so that the activated one surface of the primary sheet becomes a superposing surface as described later, the primary sheets result in being firmly adhered.

Its principle is not clear, but it is presumed that on being irradiated with VUV, C-Si bonds of the organopolysiloxane change to Si-O bonds such as Si-OH, and the primary sheets are firmly adhered through the Si-O bonds. That is, the primary sheet and the primary sheet (unit layers 13, 13) are adhered by generated intermolecular bonds of the organopolysiloxane.

The VUV irradiation condition is not especially limited as long as being a condition of being capable of activating the surface of the primary sheet, but the VUV irradiation may be carried out so that the integrated light quantity becomes, for example, 5 to 100 mJ/cm² and preferably 10 to 50 mJ/cm².

### (Lamination step)

Then, a plurality of the primary sheets 21, as shown in Figs. 2(a) and (b), are laminated so that the orientation directions of the anisotropic fillers 14 become the same. Here, in each primary sheet 21, it suffices as long as one surface of superposing surfaces thereof contacting with each other is previously irradiated with VUV as described above. Neighboring primary sheets 21, 21 are mutually adhered by the activated one surface made by irradiating one surface with VUV. Further from the viewpoint of improving the adhesion, it is preferable that both of the superposing surfaces are VUV irradiated.

That is, as shown in Fig. 2(a), it suffices if the primary sheet 21 is superposed so that one surface thereof 21A irradiated with VUV is brought into contact with another primary sheet 21, but at this time, it is preferable that another surface 21B of the another primary sheet 21 is also VLTV irradiated.

Although the primary sheet 21 is capable of being adhered only by being superposed as described above, in order to make the adhesion firmer, the primary sheets 21 may be pressed in the lamination direction x. The pressing is carried out preferably at a pressure in a degree of not largely deforming the primary sheet 21, and can be carried out, for example, by using a roller or a press. As one example, in the case of using a roller, the pressure is preferably made to be 0.3 to 3 kgf/50 mm.

Laminated primary sheets 21, for example, in being pressed, may suitably be heated, but since the primary sheet 21 activated by the VUV irradiation can be adhered without being heated, it is preferable that the laminated primary sheets 21 are not heated. Therefore, the temperature in the pressing is, for example, about 0 to 50°C and preferably about 10 to 40°C.

### (Cutting step)

Then, as shown in Fig. 2(c), the laminated block 22 is cut along the lamination direction x of the primary sheets 21 by a blade 18 to thereby obtain the heat-conducting sheet 10. At this time, the laminated block 22 is cut in the direction orthogonal to the orientation direction of the anisotropic filler 14. As the blade 18, there can be used, for example, a single-edged or double-edged blade such as a razor blade or a cutter knife, a round blade, a wire blade or a saw blade. The laminated block 22 is cut by using the blade 18, for example, by a method of press-cutting, shearing, rotating or sliding.

Then, although in the above production method, there has been described the example of using the curing silicone composition, which is cured by being heated, as a raw material of the silicone resin, the raw material of the silicone resin is not limited to a composition having curability and a composition having no curability may be used. In such a case, as the liquid composition, there is used preferably a mixture, diluted with an organic solvent, of the silicone resin, the heat-conducting filler and additive components blended as required. The liquid composition diluted with the organic solvent is formed into a sheet shape and dried to make a primary sheet, and the primary sheet obtained by the drying is irradiated with VUV.

### [Second embodiment]

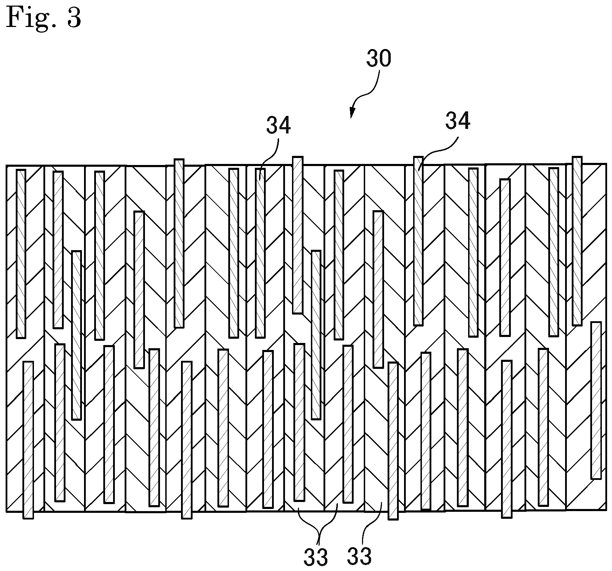

Then, a heat-conducting sheet according to a second embodiment of the present invention will be described by using Fig. 3.

Although the heat-conducting sheet 10 in the first embodiment contains, as the heat-conducting filler, in addition to the anisotropic filler 14, the non-anisotropic filler 15, a heat-conducting sheet 30 of the present embodiment, as shown in Fig. 3, contains no non-anisotropic filler. That is, each unit layer 33 of the heat-conducting sheet of the second embodiment contains an anisotropic filler 34 oriented in the thickness direction of the sheet 30, but contains no non-anisotropic filler.

Since the other constitutions of the heat-conducting sheet 30 of the second embodiment are the same as in the above heat-conducting sheet 10 of the first embodiment, except for containing no non-anisotropic filler, their description will be omitted.

Also in the present embodiment, as in the first embodiment, the compression ratio of the heat-conducting sheet 30 when being compressed at 0.276 MPa becomes 20 to 65%, so the heat-conducting sheet 30 is good in the flexibility and can be used by being compressed inside electronic devices. The heat-conducting sheet 30 can suitably be produced without almost no occurrence of spreading-out of each unit layer 33 at a pressure in lamination of the unit layers 33.

Since neighboring unit layers 33 are adhered on condition that the adhesive surface has been activated with VUV irradiation, the neighboring unit layers 33 are firmly adhered and the above compression ratio can be secured without impairing the flexibility.

Then, the heat-conducting sheet of the present invention is not limited to the above constitutions of the first embodiment and the second embodiment and can have various types of forms. For example, although in the first embodiment, the heat-conducting sheet contains, as the heat-conducting filler, both of the anisotropic filler and the non-anisotropic filler, it is allowed that a heat-conducting sheet contains no anisotropic filler and contains the non-anisotropic filler alone.

In the case of containing no anisotropic filler, when a primary sheet is formed, there is no need of imparting a shearing force in order to orient the anisotropic filler, and the primary sheet may be formed by any method as long as being a method of being capable of forming a liquid composition into a sheet shape.

Although in the above description, a form in which each unit layer in the heat-conducting sheet has substantially the same composition is described, the compositions of each unit layer may be different from one another.

For example, in the above description, although all unit layers in the heat-conducting sheet contain a heat-conducting filler, it is allowed that at least one unit layer contains a heat-conducting filler and the other unit layers contain no heat-conducting filler. In such a case, since the various constitutions of the heat-conducting filler, the silicone resin, the heat-conducting sheet and the like are as described above in the first embodiment and the second embodiment, except for that some unit layers contain no heat-conducting filler, their descriptions will be omitted. Further in the production method, it is allowed that at least one of the primary sheets of a plurality of primary sheets contains a heat-conducting filler, and the other primary sheets contain no heat-conducting filler.

Although for example, in the first embodiment, all unit layers contain both of an anisotropic filler and a non-anisotropic filler, it is allowed that some unit layers contain both the anisotropic filler and the non-anisotropic filler, and some unit layers contain one of the anisotropic filler and the non-anisotropic filler.

Then, for example, it is allowed that some unit layers contain the anisotropic filler alone, and some unit layers contain the non-anisotropic filler 15 alone.

In each unit layer, there is no need for the contents of the heat-conducting filler to be identical to each other and the contents of the heat-conducting filler in some unit layers and the contents of the heat-conducting filler in the other unit layers may be made different. Further the kind of the heat-conducting filler in some unit layers may be made different from the kind of the heat-conducting filler in the other unit layers.

It is allowed that by suitably regulating the presence and absence of the content, the content, the kind and the like of the heat-conducting filler in each unit layer as described above, the thermal conductivity of some unit layers is made to be higher than the thermal conductivity of the other unit layers. In such a case, unit layers having a higher thermal conductivity and unit layers having a lower thermal conductivity may be alternately arranged, but there is no need of the alternate arrangement.

The electroconductivity of some unit layers may be made to be lower than that of the other unit layers. Also, in such a case, the unit layers having a high electroconductivity and the unit layers having a low electroconductivity may be alternately arranged, but there is no need of the alternate arrangement. By making the electroconductivity of some unit layers to be lower than that of the other unit layers, the electrical conductivity along the lamination direction x (see Fig. 1) is hindered by some unit layers having a lower electroconductivity. Hence, the electroconductivity in the lamination direction x as the whole heat-conducting sheet becomes low and it becomes easy for the insulativeness to be secured. Here, in order to more secure the insulativeness, it is preferable that the unit layers having a lower electroconductivity are made to contain no heat-conducting filler.

Further it is allowed that some unit layers among the plurality of unit layers are made unit layers having thermal conduction, and the other unit layers are made unit layers having light transmission. The unit layers having thermal conduction are layers containing, as described above, the heat-conducting filler, preferably both of the anisotropic filler and the non-anisotropic filler. On the other hand, the unit layers having light transmission may be made to be, for example, layers containing no heat-conducting filler. According to such constitutions, the heat-conducting sheet also as a whole results in having the thermal conduction and the light transmission in certain levels along the thickness direction. The unit layers having thermal conduction and the unit layers having light transmission may be alternately arranged, but there is no need of the alternate arrangement.

Of course, the constitutions excluding the electrical conductive filler may be varied for each unit layer. For example, the kind of the silicone resin of some unit layers may be varied to the kind of the silicone resin of the other unit layers. Further, the presence and absence of additive components, the kinds and amounts of the additive components, and the like in some unit layers may be made to be different from those of the other unit layers.

For example, by making part of the kind or amount of the silicone resin and the kind or amount of the heat-conducting filler in some unit layers to be different from the part of the other unit layers, the hardness (type OO hardness) of some unit layers may be made different from that of the other unit layers.

### Examples

Hereinafter, the present invention will be described in more detail by way of Examples, but the present invention is not any more limited to these Examples.

In the present Examples, physical properties of heat-conducting sheets were evaluated by the following methods.

### [Compression ratio]

A heat-conducting sheet was cut into a size of 10 mm × 10 mm, and the compression ratio when the sheet was compressed at 0.276 MPa (= 40 psi) was measured. Specifically, the test piece was interposed between a platen whose surface was flat in a size of 10 mm × 10 mm and a parallelly pressing presser, and the thickness T2 when the test piece was compressed at 0.276 MPa was measured; and the compression ratio to the initial thickness T1, (T1 - T2)/T1, was calculated.

### [Hardness]

The type OO hardness of a heat-conducting sheet and a primary sheet was measured according to ASTM D2240-05. Then, the type OO hardness was calculated as an average value obtained by regulating the thickness of a test piece to 10 mm and measuring hardness of both surfaces of the test piece. Here, in the case where the thickness was smaller than 10 mm, a plurality of sheets were stacked and the thickness of a test piece was regulated so as to become 10 mm or have a thickness larger than 10 mm and nearest 10 mm.

### [Thermal conductivity]

The thermal conductivity of a heat-conducting sheet was measured by the method according to ASTM D5470-06.

### [Example 1]

An alkenyl group-containing organopolysiloxane (base resin) and a hydrogenorganopolysiloxane (curing agent) (100 parts by mass in total, volume filling ratio: 40% by volume) as a curing silicone composition, 120 parts by mass (volume filling ratio: 30% by volume) of a graphitized carbon fiber (average fiber length: 100 µm, aspect ratio: 10, thermal conductivity: 500 W/m.K) as an anisotropic filler, and 500 parts by mass (volume filling ratio: 30% by volume) of an aluminum oxide powder (spherical, average particle diameter: 3 µm, aspect ratio: 1.0) as a non-anisotropic filler were mixed to thereby obtain a slurry liquid composition. The viscosity at 25°C of the liquid composition was 90 Pa s.

The liquid composition was applied at 25°C in one direction on polyethylene terephthalate (PET) base material films by using a bar coater as a coating applicator. The major axis of the anisotropic filler was directed to the coating direction; and the minor axis thereof was directed to the normal direction of the coating surface. Then, the coated liquid composition was heated at 120°C for 0.5 hour to be cured to thereby obtain primary sheets of 500 µm in thickness.

Both surfaces of each obtained primary sheet were irradiated with VUV under the condition of an integrated light quantity on the surface of the primary sheet of 20 mJ/cm² at room temperature (25°C) in the air by using a VUV irradiation apparatus (trade name: Excimer MINI, manufactured by Hamamatsu Photonics K.K.). Then, 100 sheets of the primary sheets irradiated with VUV were laminated and pressed at a pressure of 1.6 kgf/50 mm by a roller in an environment of 25°C to thereby obtain a laminated block. The obtained laminated block was sliced by a cutter blade parallelly to the lamination direction and perpendicularly to the orientation direction of the anisotropic filler to thereby obtain heat-conducting sheets of 2 mm in thickness having a thickness of each unit layer of 500 µm.

### (Examples 2 to 5)

The procedure was carried out as in Example 1, except for altering the blend ratio of the base resin and the curing agent so that the hardness of primary sheets after being cured became those indicated in Table 1. In Examples 2 to 5 each, the viscosity at 25°C of the liquid composition was 90 Pa s. The thickness of the obtained heat-conducting sheets was 2 mm and the thickness of each unit layer was 500 µm.

### (Example 6)

The procedure was carried out as in Example 1, except for altering the anisotropic filler to a boron nitride (non-agglomerated flake material, average particle diameter: 40 µm, aspect ratio: 4 to 8, thermal conductivity: 100 W/m.K), and altering parts thereof added to 180 parts by mass. The thickness of the obtained heat-conducting sheet was 2 mm and the thickness of each unit layer was 500 µm. The filling ratio of the anisotropic filler was 26% by volume; that of the non-anisotropic filler was 41% by volume; and that of the silicone resin was 33% by volume. The normal direction of the flake surface of the anisotropic filler was directed to the lamination direction.

### (Example 7)

The procedure was carried out as in Example 1, except for altering the anisotropic filler to a flake carbon powder (average particle diameter: 130 µm, aspect ratio: 4 to 8, thermal conductivity: 400 W/m.K). The thickness of the obtained heat-conducting sheet was 2 mm and the thickness of each unit layer was 500 µm. The filling ratio of the anisotropic filler was 19% by volume; that of the non-anisotropic filler was 45% by volume; and that of the silicone resin was 36% by volume. The normal direction of the flake surface of the anisotropic filler was directed to the lamination direction.

### (Comparative Example 1)

Primary sheets were fabricated by the same method as in Example 1. The obtained primary sheets were not irradiated with VUV; and instead thereof, an adhesive agent ("XY Primer", manufactured by Dow Corning Toray Co., Ltd.) was applied on one surface of one primary sheet, and another primary sheet was superposed on the one surface through the adhesive agent; this operation was repeated to laminate 100 sheets of the primary sheets to thereby obtain a laminated block. Thereafter, heat-conducting sheets of 2 mm in thickness were obtained by the same method as in Example 1. The thickness of each unit layer was 500 µm.

### (Comparative Example 2)

Primary sheets were fabricated by the same method as in Example 1, except for altering the blend ratio of the base resin and the curing agent so that the hardness became OO25 when the curing condition of the curing silicone composition was altered to at 70°C for 15 min, and curing the curing silicone composition at 70°C for 15 min. The primary sheets were not completely cured and were in a semi-cured state.

The obtained primary sheets were not irradiated with VUV, and 100 sheets of the primary sheets were laminated; the resultant laminated body was pressed at a pressure of 1.6 kgf/50 mm by a roller in an environment of 25°C, and thereafter further heated at 120°C for 1 hour to be completely cured to thereby obtain a laminated block. Thereafter, heat-conducting sheets of 2 mm in thickness were obtained by the same method as in Example 1. The thickness of each unit layer was 50 µm. The hardness after complete curing was OO79.

### (Comparative Example 3)

The procedure was carried out as in Example 1, except for not irradiating the primary sheets with VUV.

### (Comparative Example 4)

Primary sheets were fabricated as in Example 2. The obtained primary sheets were not irradiated with VUV; and instead thereof, an adhesive agent ("XY Primer", manufactured by Dow Corning Toray Co., Ltd.) was applied on one surface of one primary sheet, and another primary sheet was superposed on the one surface through the adhesive agent; this operation was repeated to laminate 100 sheets of the primary sheets to thereby obtain a laminated block. Thereafter, heat-conducting sheets of 2 mm in thickness were obtained by the same method as in Example 1. The thickness of each unit layer was 500 µm.

### (Comparative Example 5)

Primary sheets were fabricated by the same method as in Comparative Example 2, except for using the same curing silicone composition as in Example 1. That is, in Comparative Example 5, the same curing silicone composition as in Example 1 was heated at 70°C for 15 min to be made into a semi-cured state.

The obtained primary sheets were not irradiated with VUV; and 100 sheets of the primary sheets were laminated; the resultant laminated body was pressed at a pressure of 1.6 kgf/50 mm by a roller in an environment of 25°C, and thereafter further heated at 120°C for 1 hour to be completely cured. The laminated body whose height was 25 mm before the pressing, however, collapsed by the pressing, and a predetermined laminated block could not be obtained.

### (Comparative Example 6)

Primary sheets were fabricated by the same method as in Example 2, except for altering the blend ratio of the base resin and the curing agent so that the hardness became OO8 when the curing condition of the curing silicone composition was altered to at 70°C for 15 min, and curing the curing silicone composition at 70°C for 15 min. The primary sheets were not completely cured and were in a semi-cured state.

The obtained primary sheets were not irradiated with VUV, and 100 sheets of the primary sheets were laminated; the resultant laminated body was pressed at a pressure of 1.6 kgf/50 mm by a roller in an environment of 25°C, and thereafter further heated at 120°C for 1 hour to be completely cured to thereby obtain a laminated block. At this time, the laminated body whose height was 25 mm before the pressing collapsed by the pressing down to 20 mm. Thereafter, heat-conducting sheets of 2 mm in thickness were obtained by the same method as in Example 1. Although unit layers were completely unified and no boundaries could be distinguished, from the collapsing amount of the laminated block, the thickness of each unit layer was 400 µm.

**[Table 1]**

| | Example 1 | Example 2 | Example 3 | Example 4 | Example 5 | Example 6 | Example 7 | Comparative Example 1 | Comparative Example 2 | Comparative Example 3 | Comparative Example 4 | Comparative Example 5 | Comparative Example 6 |
|---|---|---|---|---|---|---|---|---|---|---|---|---|---|
| Production Method | VUV lamination | VUV lamination | VUV lamination | VUV lamination | VUV lamination | VUV lamination | VUV lamination | Adhesive agent lamination | Semi-cured lamination | No treatment | Adhesive agent lamination | Semi-cured lamination | Semi-cured lamination |
| 1 Hardness of Primary Sheet | 0025 | 008 | 0018 | 0037 | 0048 | 0025 | 0025 | 0025 | 0025 | 0025 | 008 | 003 | 008 |
| Deficiencies in Lamination Step | None | Slight spreading-out occurred, but lamination was possible | None | None | None | None | None | None | None | None | Slight spreading-out occurred, but lamination was possible | Spreading-out occurred at a pressure in lamination and the lamination up to a predetermined thickness could not be made | Slight spreading-out occurred, but lamination was possible |
| Exfoliation in Cutting Step | None | None | None | None | None | None | None | None | None | Interlayer exfoliation occurred | None | - | None |
| Hardness of Heat-Conducting Sheet | 0045 | 0019 | 0038 | 0055 | 0062 | 0045 | 0045 | OO70 | 0079 | 0045 | 0065 | - | 0068 |
| Thermal Conductivity of Heat-Conducting Sheet (W/(m·K)) | 11 | 9 | 11 | 12 | 13 | 7 | 10 | 12 | 10 | 7 | 9 | - | 9 |
| Compression ratio of Heat-Conducting Sheet (%)) | 40 | 65 | 50 | 27 | 20 | 40 | 35 | 10 | 5 | 40 | 16 | - | 13 |

In the above Examples 1 to 7, by adhering unit layers with VUV irradiation, the flexibility could be raised in the heat-conducting sheets using the silicone resin as a matrix component and being constituted by laminating a large number of unit layers. In Example 2, since the amount of the curing agent was small and the primary sheets were relatively flexible, the primary sheets somewhat spread out by the pressing in lamination of the primary sheets, but the laminated block having a sufficient thickness was fabricated.

By contrast, in Comparative Examples 1, 2, 4 and 6, since no VUV irradiation was used for adhesion of primary sheets, the flexibility of the obtained heat-conducting sheets was insufficient. In Comparative Example 3, since no treatment for mutually adhering the primary sheets was carried out, the primary sheets were not mutually adhered, and exfoliation interlayerly occurred when the laminated block was sliced, so that no heat-conducting sheet could be fabricated. In Comparative Example 5, since the primary sheets were too flexible, the primary sheets spread out by the pressing in lamination of the primary sheets, so that no laminated block having a sufficient thickness could be fabricated. On the other hand, in Comparative Example 6, although the laminated block could be fabricated from the semi-cured primary sheets having a hardness in the same degree as in Example 2, the flexibility after the complete curing was insufficient.

### Reference Signs List

10, 30 HEAT-CONDUCTING SHEET
10A, 21A ONE SURFACE
10B, 21B ANOTHER SURFACE
11 SILICONE RESIN
13, 33 UNIT LAYER
14, 34 ANISOTROPIC FILLER
15 NON-ANISOTROPIC FILLER
18 BLADE
21 PRIMARY SHEET
22 LAMINATED BLOCK

## Claims

1. A heat-conducting sheet, comprising a plurality of unit layers each comprising a silicone resin, the plurality of unit layers being laminated so as to be adhered with each other, at least one of the plurality of unit layers comprising a heat-conducting filler; **characterized in that** the heat-conducting sheet having a compression ratio of 20 to 65% as measured when the heat-conducting sheet is compressed at 0.276 MPa from the direction perpendicular to adhesion surfaces of the plurality of unit layers adhered with each other.

2. The heat-conducting sheet according to claim 1, wherein the plurality of unit layers are laminated along one direction along the sheet plane direction.

3. The heat-conducting sheet according to claim 1 or 2, wherein the heat-conducting filler comprises an anisotropic filler.

4. The heat-conducting sheet according to claim 3, wherein the heat-conducting filler further comprises a non-anisotropic filler.

5. The heat-conducting sheet according to claim 3 or 4, wherein the anisotropic filler is oriented in the sheet thickness direction.

6. The heat-conducting sheet according to any one of claims 3 to 5, wherein the anisotropic filler is at least one selected from the group consisting of fibrous materials and flake materials.

7. The heat-conducting sheet according to claim 6, wherein the normal direction of the flake plane of the flake material is directed to the lamination direction of the plurality of unit layers.

8. The heat-conducting sheet according to any one of claims 1 to 7, wherein neighboring unit layers are mutually directly adhered.

9. A method for producing a heat-conducting sheet, comprising:
a step of preparing a plurality of primary sheets each comprising a silicone resin and having at least one of the primary sheets comprising a heat-conducting filler;
a step of irradiating at least one surface of the primary sheet with vacuum ultraviolet rays;
a step of laminating the plurality of primary sheets so that each one surface irradiated with vacuum ultraviolet rays is brought into contact with another primary sheet, to adhere the plurality of primary sheets to thereby form a laminated block; and
a step of cutting the laminated block along the lamination direction so as to make a sheet shape, to thereby obtain the heat-conducting sheet.

10. The method for producing a heat-conducting sheet according to claim 9, wherein the heat-conducting filler comprises an anisotropic filler, and the primary sheet comprises the anisotropic filler oriented along the sheet plane direction; and
the laminated block is cut in the direction orthogonal to the orientation direction of the anisotropic filler.

## Patentansprüche

1. Wärmeleitende Folie, umfassend eine Vielzahl von Einheitsschichten, die jeweils ein Silikonharz umfassen, wobei die Vielzahl von Einheitsschichten so laminiert ist, dass sie aneinander haften, wobei mindestens eine der Vielzahl von Einheitsschichten einen wärmeleitenden Füllstoff umfasst, **dadurch gekennzeichnet, dass** die wärmeleitende Folie ein Kompressionsverhältnis von 20 bis 65% aufweist, gemessen, wenn die wärmeleitende Folie bei 0,276 MPa aus der Richtung senkrecht zu den Haftflächen der Vielzahl von aneinander haftenden Einheitsschichten komprimiert wird.

2. Wärmeleitende Folie nach Anspruch 1, wobei die Vielzahl von Einheitsschichten entlang einer Richtung entlang der Richtung der Folienebene laminiert sind.

3. Wärmeleitende Folie nach Anspruch 1 oder 2, wobei der wärmeleitende Füllstoff einen anisotropen Füllstoff umfasst.

4. Wärmeleitende Folie nach Anspruch 3, wobei der wärmeleitende Füllstoff außerdem einen nicht-anisotropen Füllstoff umfasst.

5. Wärmeleitende Folie nach Anspruch 3 oder 4, wobei der anisotrope Füllstoff in Richtung der Foliendicke orientiert ist.

6. Wärmeleitende Folie nach einem der Ansprüche 3 bis 5, wobei der anisotrope Füllstoff mindestens einer ist, ausgewählt aus der Gruppe bestehend aus faserigen Materialien und Flockenmaterialien.

7. Wärmeleitende Folie nach Anspruch 6, wobei die Normalrichtung der Flockenebene des Flockenmaterials auf die Laminierungsrichtung der Vielzahl von Einheitsschichten gerichtet ist.

8. Wärmeleitende Folie nach einem der Ansprüche 1 bis 7, wobei benachbarte Einheitsschichten direkt miteinander verklebt sind.

9. Verfahren zur Herstellung einer wärmeleitenden Folie, umfassend:
einen Schritt der Herstellung einer Vielzahl von Primärfolien, von denen jede ein Silikonharz enthält und mindestens eine der Primärfolien einen wärmeleitenden Füllstoff enthält;
einen Schritt des Bestrahlens mindestens einer Oberfläche der Primärfolie mit Vakuum-Ultraviolettstrahlen;
einen Schritt des Laminierens der Vielzahl von Primärfolien, so dass jede mit Vakuum-Ultraviolettstrahlen bestrahlte Oberfläche mit einer anderen Primärfolie in Kontakt gebracht wird, um die Vielzahl von Primärfolien zu verkleben und dadurch einen laminierten Block zu bilden; und
einen Schritt des Schneidens des laminierten Blocks entlang der Laminierungsrichtung, um eine Folienform herzustellen, um dadurch die wärmeleitende Folie zu erhalten.

10. Verfahren zur Herstellung einer wärmeleitenden Folie nach Anspruch 9, wobei der wärmeleitende Füllstoff einen anisotropen Füllstoff umfasst und die Primärfolie den anisotropen Füllstoff umfasst, der entlang der Richtung der Folienebene ausgerichtet ist, und
der laminierte Block in der Richtung orthogonal zur Orientierungsrichtung des anisotropen Füllstoffs geschnitten wird.

## Revendications

1. Feuille thermoconductrice, comportant une pluralité de couches unitaires comportant chacune une résine de silicone, les couches de la pluralité de couches unitaires étant stratifiées de manière à adhérer les unes aux autres, au moins une couche de la pluralité de couches unitaires comportant une charge thermoconductrice ; **caractérisée en ce que** la feuille thermoconductrice a un taux de compression de 20 à 65 % tel que mesuré lorsque la feuille thermoconductrice est comprimée à 0,276 MPa à partir de la direction perpendiculaire à des surfaces d'adhérence de la pluralité de couches unitaires adhérant les unes aux autres.

2. Feuille thermoconductrice selon la revendication 1, dans laquelle les couches de la pluralité de couches unitaires sont stratifiées le long d'une direction le long de la direction du plan de feuille.

3. Feuille thermoconductrice selon la revendication 1 ou 2, dans laquelle la charge thermoconductrice est une charge anisotrope.

4. Feuille thermoconductrice selon la revendication 3, dans laquelle la charge thermoconductrice comporte en outre un charge non anisotrope.

5. Feuille thermoconductrice selon la revendication 3 ou 4, dans laquelle la charge anisotrope est orientée dans la direction d'épaisseur de feuille.

6. Feuille thermoconductrice selon l'une quelconque des revendications 3 à 5, dans laquelle la charge anisotrope est au moins un élément choisi parmi le groupe constitué de matériaux fibreux et de matériaux en flocons.

7. Feuille thermoconductrice selon la revendication 6, dans laquelle la direction normale du plan de flocons du matériau en flocons est dirigée vers la direction de stratification de la pluralité de couches unitaires.

8. Feuille thermoconductrice selon l'une quelconque des revendications 1 à 7, dans laquelle des couches unitaires voisines adhèrent mutuellement et directement.

9. Procédé pour produire une feuille thermoconductrice, comportant :
une étape consistant à préparer une pluralité de feuilles primaires comportant chacune une résine de silicone et ayant au moins l'une des feuilles primaires comportant une charge thermoconductrice ;
une étape consistant à projeter sur au moins une surface de la feuille primaire, des rayons ultraviolets sous vide ;
une étape consistant à stratifier la pluralité de feuilles primaires de sorte que chaque surface soumise à des rayons ultraviolets sous vide est mise en contact avec une autre feuille primaire, pour faire adhérer la pluralité de feuilles primaires pour ainsi former un bloc stratifié ; et
une étape consistant à couper le bloc stratifié le long de la direction de stratification de manière à réaliser une forme de feuille, pour ainsi obtenir la feuille thermoconductrice.

10. Procédé pour produire une feuille thermoconductrice selon la revendication 9, dans lequel la charge thermoconductrice comporte une charge anisotrope, et la feuille primaire comporte la charge anisotrope orientée le long de la direction de plan de feuille ; et
le bloc stratifié est coupé dans la direction orthogonale à la direction d'orientation de la charge anisotrope.
